# EUROPEAN PATENT APPLICATION

(11) **EP 4 727 308 A1**
(43) Date of publication of application: **15.04.2026**
(21) Application number: 25204360.9
(22) Date of filing: 24.09.2025
(51) Int. Cl.: H10H 29/30, H10H 29/85, H10H 29/856, H10H 20/832, H10H 20/85

(54) **ELECTRONIC DEVICE**

(30) Priority: 11.10.2024 CN 202411416029
(71) Applicant: InnoLux Corporation, Jhu-Nan 350, Miao-Li County (TW)
(72) Inventor: YAN, Tzu-Min, Jhu-Nan (TW); WU, Che-I, Jhu-Nan (TW)
(74) Representative: dompatent

(57) **Abstract**

An electronic device includes a substrate, a circuit layer, a semiconductor chip, and a sensing element. The circuit layer is disposed on the substrate. The semiconductor chip is disposed over the substrate and the circuit layer, and is electrically connected to the circuit layer. The semiconductor chip includes a semiconductor die, an underfill layer surrounding the semiconductor die, a reflective layer arranged around the underfill layer, and a transparent conductive layer arranged on the semiconductor die and electrically connected to the circuit layer. The sensing element is at least partially overlapped with the substrate.

## Description

### BACKGROUND

### Technology Field

The present invention relates to an electronic device and, in particular, to an electronic device containing a semiconductor chip and a sensing element.

### Description of Related Art

With the development of digital technology, electronic devices with display panels have been widely used in all aspects of daily life, such as modem information products (e.g. TVs, computers, mobile phones, or the likes). Among the common display panels, the micro LED display panel is one of the current mainstream products.

### SUMMARY

This invention provides an electronic device that includes a semiconductor chip (e.g. micro LED) and a sensing element (e.g. a sensor) arranged on one circuit substrate.

An electronic device of this invention includes a substrate, a circuit layer, a semiconductor chip, and a sensing element. The circuit layer is disposed on the substrate. The semiconductor chip is disposed over the substrate and the circuit layer and electrically connected to the circuit layer. The semiconductor chip includes a semiconductor die, an underfill layer surrounding the semiconductor die, a reflective layer arranged around the underfill layer, and a transparent conductive layer arranged on the semiconductor die and electrically connected to the circuit layer. The sensing element is at least partially overlapped with the substrate.

### BRIEF DESCRIPTION OF THE DRAWINGS

The invention will become more fully understood from the detailed description and accompanying drawings, which are given for illustration only, and thus are not limitative of the present invention, and wherein:
FIG. 1 is a schematic diagram showing an electronic device according to a first embodiment of this invention;
FIG. 2 is a schematic diagram showing an electronic device according to a second embodiment of this invention;
FIG. 3 is a schematic diagram showing an electronic device according to a third embodiment of this invention;
FIG. 4 is a schematic diagram showing an electronic device according to a fourth embodiment of this invention;
FIG. 5 is a schematic diagram showing an electronic device according to a fifth embodiment of this invention;
FIG. 6 is a schematic diagram showing an electronic device according to a sixth embodiment of this invention; and
FIG. 7 is a schematic diagram showing an electronic device according to a seventh embodiment of this invention.

### DETAILED DESCRIPTION OF THE INVENTION

The present invention will be apparent from the following detailed description, which proceeds with reference to the accompanying drawings, wherein the same references relate to the same elements.

It should be understood that the following description provides different embodiments for implementing different aspects of some embodiments of the present invention. The specific components and arrangements described below are used to briefly and clearly describe some embodiments of the present invention. These embodiments are for illustrations and are not intended to limit the scope of the present invention. In addition, reference numbers or labels may be repeatedly used in different embodiments. These repetitions are for the purpose of simply and clearly describing some embodiments of the present invention, and do not represent any correlation between the different embodiments and/or structures discussed. Furthermore, when it is mentioned that a certain layer is on or above another layer, the certain layer may directly contact another layer, or one or more other layers or films may be provided between the two layers, so that the certain layer may not directly contact another layer.

Relative terms, such as "lower" and "higher", or "bottom" and "top", may be used in following embodiments to describe the relative relationship of one component to another component in the drawings. It will be understood that if the device shown in the drawings is turned upside down, components described as being at the "lower" side would then be at the "higher" side.

The terms "about", "approximate" and "approximately" usually mean the variation within 20%, preferably within 10%, and more preferably within 5%, 3%, 2%, 1% or 0.5% of a given value or range. The given quantities here are approximate quantities, that is, in the absence of specific description of "about", "approximate", or "approximately", the meaning of "about", "approximate", and "approximately" can still be implied.

It will be understood that, although the terms "first", "second", "third" and the likes may be used herein to describe various elements, components, regions, layers, and/or portions, these elements, components, regions, layers, and/or portions should not be limited by these terms, and these terms are used to distinguish between different elements, components, regions, layers, and/or portions. Thus, a first element, component, region, layer, and/or portion discussed below could be termed a second element, component, region, layer, and/or portion without departing from the teachings of some embodiments of the present invention.

Unless otherwise defined, all terms (including technical and scientific terms) used herein have the same meaning as commonly understood by one of ordinary skill in the related art. It is understood that these terms, such as those defined in commonly used dictionaries, should be interpreted to have a meaning consistent with the relevant technology and the background or content of the present invention, and should not be interpreted in an idealized or overly formal way, unless otherwise defined in the embodiments of this invention.

Some embodiments of the present invention can be understood together with the drawings, and the drawings of the embodiments of the present invention are also regarded as part of the description of the embodiments of the present invention. It should be understood that the drawings of the embodiments of the present invention are not drawn to the actual scale of devices and components. The shapes and thicknesses of embodiments may be exaggerated in the drawings to clearly illustrate features of embodiments of the present invention. In addition, the structures and devices in the drawings are illustrated in a schematic manner in order to clearly demonstrate the features of the embodiments of the present invention.

In some embodiments of the present invention, relative terms such as "lower", "upper", "parallel", "vertical", "below", "above", "top", "bottom", etc., shall be understood as the orientations shown in this paragraph and related drawings. This relative terms are for convenience of explanation and does not mean that the device described needs to be manufactured or operated in a specific orientation. Terms related to joining and connecting, such as "connect", "joint", etc., unless otherwise defined, can mean that two structures are in direct contact, or they can also mean that the two structures are not in direct contact with one or more additional structures located therebetween. The terms related to joining and connecting two structures can also include the situation that both structures are movable, or both structures are fixed.

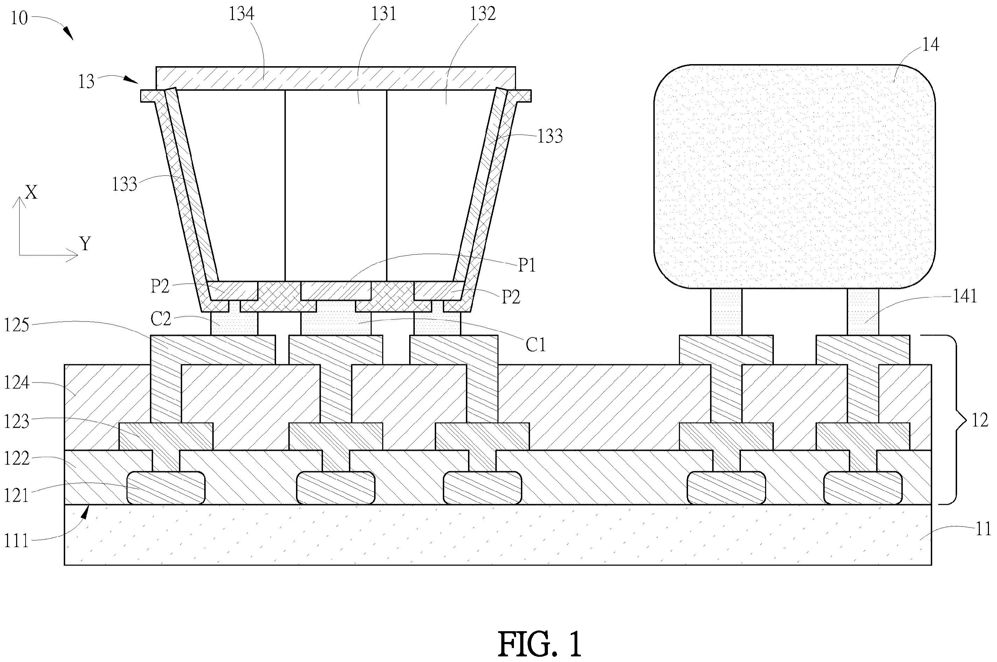

FIG. 1 is a schematic diagram showing an electronic device 10 according to a first embodiment of this invention.

As shown in FIG. 1, in this embodiment, the electronic device 10 includes a substrate 11, a circuit layer 12, a semiconductor chip 13, and a sensing element 14. The circuit layer 12 is disposed on the substrate in the first direction X. The semiconductor chip 13 is disposed over the substrate 11 and the circuit layer 12 in the first direction, and is electrically connected to the circuit layer 12. The semiconductor chip 13 includes a semiconductor die 131, an underfill layer 132 surrounding the semiconductor die 131, a reflective layer 133 arranged around the underfill layer 132, and a transparent conductive layer 134 arranged on the semiconductor die 131. The transparent conductive layer 134 is electrically connected to the circuit layer 12. The sensing element 14 is at least partially overlapped with the substrate 11 in the first direction X. The semiconductor chip 13 and the sensing element 14 are arranged over the circuit layer 12 in the second direction Y.

As mentioned above, the substrate 11 may include, for example but not limited to, transparent or non-transparent organic and/or inorganic material, and the material thereof may include rigid material or flexible soft material. The organic material may include, for example but not limited to, polyimide (PI), polycarbonate (PC), polyethylene terephthalate (PET), or any of other known suitable materials, or a combination thereof. The inorganic material may include, for example but not limited to, glass, quartz, sapphire, or ceramic. In this embodiment, the material of the substrate 11 is glass as an example, so that the substrate 11 is a glass substrate.

The circuit layer 12 may include one or more metal layers and one or more insulating layers stacked alternately in the first direction X. The circuit layer 12 may include, for example, different passive components and/or active components, such as resistors, capacitors, inductors, diodes, MOSFETs, CMOS transistors, BJTs, LDMOS transistors, PMOS transistors, TFTs, or other types of transistors. For example, the circuit layer 12 may further include a semiconductor layer (not shown), and the thin-film transistors may be formed by patterning the semiconductor layer and the metal layer(s). In addition, the substrate 11 and the circuit layer 12 can together constitute a driving substrate for driving the semiconductor chip 13 and/or the sensing element 14. In this embodiment, the substrate 11 can be, for example but not limited to, a CMOS substrate, a LCOS substrate, a TFT substrate, or other circuit substrates with working circuits. To be noted, the above description is for an illustration, and is not intended to limit the scope of the present invention.

Referring to FIG. 1, the circuit layer 12 of this embodiment includes, for example, three metal layers 121, 123 and 125, and two insulating layers 122 and 124. The metal layer 121 is disposed on a first surface 111 of the substrate 11 in the first direction X. The insulating layer 122 is disposed on the first surface 111 of the substrate 11 in the first direction X and covers the metal layer 121. The metal layer 123 is disposed on the insulating layer 122 in the first direction X. The insulating layer 124 is disposed on the insulating layer 122 in the first direction X and covers the metal layer 123. The metal layer 125 is disposed on the insulating layer 124 in the first direction X. In addition, the insulating layer 122 has a plurality of vias relative to the metal layer 121, and the metal layer 123 can be further formed in the vias of the insulating layer 122 for electrically connecting to the metal layer 121. The insulating layer 124 has a plurality of vias relative to the metal layer 123, and the metal layer 125 can be further formed in the vias of the insulating layer 124 for electrically connecting to the metal layer 123. To be noted, the above description is for an illustration, and is not intended to limit the scope of the present invention.

The semiconductor chip 13 may be, for example but not limited to, a vertical embedded flip chip (VEFC) or a vertical embedded chip (VEC). In this embodiment, the semiconductor chip 13 is, for example but not limited to, a VEC. In the semiconductor chip 13 as shown in FIG. 1, the semiconductor die 131 may be, for example but not limited to, a vertical-type LED die, which includes a p-type semiconductor layer located at the upper side, an n-type semiconductor layer located at the lower side, and a light-emitting layer disposed between the p-type semiconductor layer and the n-type semiconductor layer. The n-type semiconductor layer may be directly electrically connected to the metal layer 125 (i.e., the circuit layer 12) through a conductive member C1 and/or a connecting pad P1, and the p-type semiconductor layer may be electrically connected to the metal layer 125 (i.e., the circuit layer 12) through the transparent conductive layer 134, the reflective layer 133, another conductive member C2 and/or another connecting pad P2. In this case, the reflective layer 133 may be, for example but not limited to, a metal coating, which can be made of, for example but not limited to, silver, aluminum, tin, indium, gold, or any combination thereof. The reflective layer 133 may be configured to provide both a reflective function and a conductive function. The transparent conductive layer 134 may include a transparent conductive material such as, for example, metal oxide, graphene, other suitable transparent conductive materials, or any combination thereof. The metal oxide may include indium tin oxide (ITO), indium zinc oxide (IZO), aluminum tin oxide, aluminum zinc oxide, indium germanium zinc oxide, or any of other metal oxides. Alternatively, the transparent conductive material may include a thin metal or a metal grid. For example, the transparent conductive material may form a thin metal layer, such as a magnesium layer or a silver layer. In another case, the transparent conductive material may form a metal grid layer having light-transmitting openings by screen printing or other patterning processes, so that the openings can allow light to pass through the transparent conductive layer. To be noted, the above description is for an illustration, and is not intended to limit the scope of the present invention.

In addition, the p-type semiconductor layer and the transparent conductive layer 134 can be formed with an ohmic contact layer (not shown) therebetween, and the n-type semiconductor layer and the connecting pad P1 can be formed with an ohmic contact layer (not shown) therebetween. The semiconductor chip 13 can be connected to the circuit layer 12 by solder bonding. In this case, the solder (not shown) can be provided between the conductive member C1 and the metal layer 125, and also be provided between another conductive member C2 and the metal layer 125. To be noted, the above description is for an illustration, and is not intended to limit the scope of the present invention.

In this embodiment as shown in FIG. 1, the sensing element 14 is disposed on the substrate 11 and electrically connected to the circuit layer 12. In this case, the sensing element 14 may be, for example but not limited to, a fingerprint sensor, a photo sensor, an acoustic sensor, or a tactile sensor. Specifically, on the projections perpendicular to the first direction X, the projection of the sensing element 14 is substantially within the range of the projection of the substrate 11 or the projection of the circuit layer 12, and the connecting pins 141 of the sensing element 14 can be directly electrically connected to the metal layer 125 (i.e., the circuit layer 12). It should be noted that since the semiconductor chip 13 of the present embodiment can be a VEFC or a VEC, which inherently includes a reflective light-collecting structure (i.e., the reflective layer 133), the reflective structure on the circuit layer 12 can be omitted. Therefore, the semiconductor chip 13 and the sensing element 14 can be arranged on the circuit layer 12 simultaneously. In other words, the integrated structure of the semiconductor chip 13 and the sensing element 14, which are arranged on the same circuit substrate, can be achieved without providing additional back plate mechanism.

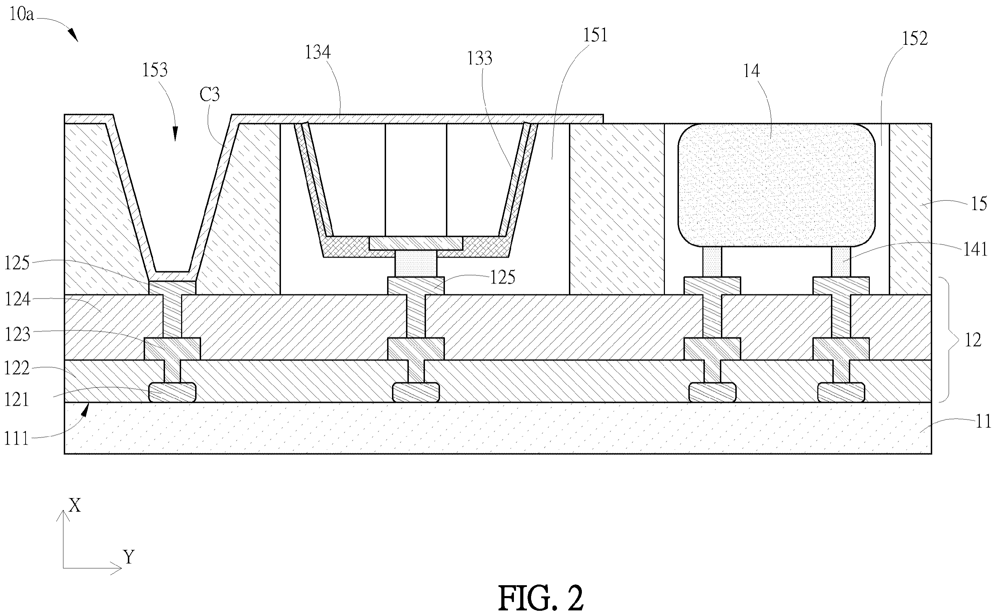

FIG. 2 is a schematic diagram showing an electronic device 10a according to a second embodiment of this invention.

The component arrangements and connections of the electronic device 10a of this embodiment are mostly the same as those of the electronic device 10 of the previous embodiment. Unlike the previous embodiment, the electronic device 10a of this embodiment further includes an insulating layer 15 disposed on the circuit layer 12. The insulating layer 15 includes a first opening 151 for accommodating the semiconductor chip 13, a second opening 152 for accommodating the sensing element 14, and a third opening 153 for electrically connecting the transparent conductive layer 134 to the circuit layer 12. In addition, the transparent conductive layer 134 extends into the third opening 153, and can be directly electrically connected to the metal layer 125 of the circuit layer 12, or can be electrically connected to the metal layer 125 of the circuit layer 12 through a connecting pad. To be noted, this invention is not limited thereto. In other embodiments, a conductive material C3 can be disposed in the third opening 153, and the transparent conductive layer 134 and the metal layer 125 of the circuit layer 12 can be electrically connected through the conductive material C3 in the third opening 153. The semiconductor chip 13 of this embodiment can be, for example but not limited to, a VEC. In other words, the conductive member C2 and/or the connecting pad P2 are/is not needed for the semiconductor chip 13 of this embodiment, and the reflective layer 133 can be made of non-conductive material, so that the p-type semiconductor layer of the semiconductor die 131 is not electrically connected to the metal layer 125 (i.e., the circuit layer 12) through the reflective layer 133. In other embodiments, the reflective layer 133 can be made of conductive material, and this invention is not limited thereto. In addition, the material of the insulating layer 15 may be, for example but not limited to, an organic photoresist material, such as a transparent, white or black organic photoresist material.

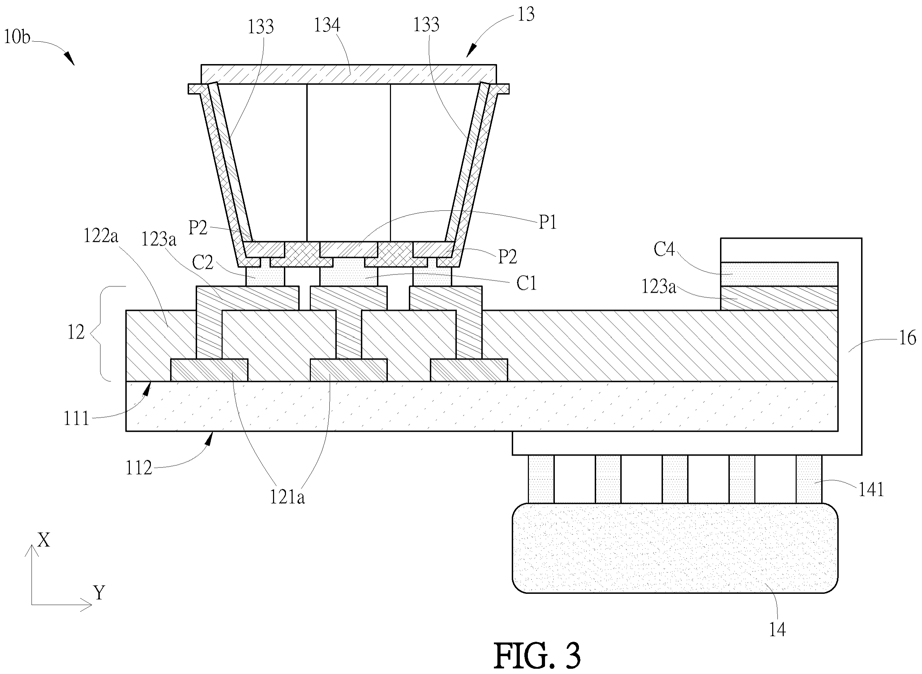

FIG. 3 is a schematic diagram showing an electronic device 10b according to a third embodiment of this invention.

The component arrangements and connections of the electronic device 10b of this embodiment are mostly the same as those of the electronic device 10 of the previous embodiment. Unlike the previous embodiment, the electronic device 10b of this embodiment further includes a flexible circuit board 16, and the sensing element 14 is disposed on the flexible circuit board 16 and is electrically connected to the circuit layer 12 through the flexible circuit board 16. In this embodiment, the flexible circuit board 16 may be formed by a chip-on-film (COF) technology. For example, the flexible circuit board 16 can be arranged at one side of the substrate 11 and the circuit layer 12, and two ends of the flexible circuit board 16 are bent toward the first surface 111 and the second surface 112 of the substrate 11, respectively. One end of the flexible circuit board 16 located on the first surface 111 can be electrically connected to the circuit layer 12 (e.g. the metal layer 123a) through a connecting member C4. The sensing element 14 is arranged on the end of the flexible circuit board 16 located on the second surface 112, so that the sensing element 14 can be located adjacent to the second surface 112 of the substrate 11, while the semiconductor chip 13 is located adjacent to the first surface 111 of the substrate 11. In addition, in the present embodiment as shown in FIG. 3, the circuit layer 12 may, for example, include a metal layer 121a, an insulating layer 122a, and a metal layer 123a. The metal layer 121a is defined on the first surface 111 of the substrate 11, the insulating layer 122a is disposed on the metal layer 121a and the first surface 111 of the substrate 11 in the first direction X, and the metal layer 123a is disposed on the insulating layer 122a in the first direction X. The insulating layer 122a has a plurality of vias relative to the metal layer 121a, and the metal layer 123a may extend in the vias of the insulating layer 122a so as to be electrically connected to the metal layer 121a. To be noted, the metal layer 121a may define a drain or a source of a thin-film transistor, but the present invention is not limited thereto. In addition, the n-type semiconductor layer arranged at the lower side of the semiconductor chip 13 can be directly electrically connected to the metal layer 123a (i.e., the circuit layer 12) through the conductive member C1 and/or the connecting pad P1, and the p-type semiconductor layer arranged at the upper side of the semiconductor chip 13 can be electrically connected to the metal layer 123a (i.e., the circuit layer 12) through the transparent conductive layer 134, the reflective layer 133, another conductive member C2 and/or another connecting pad P2. To be noted, the above description is for an illustration, and is not intended to limit the scope of the present invention.

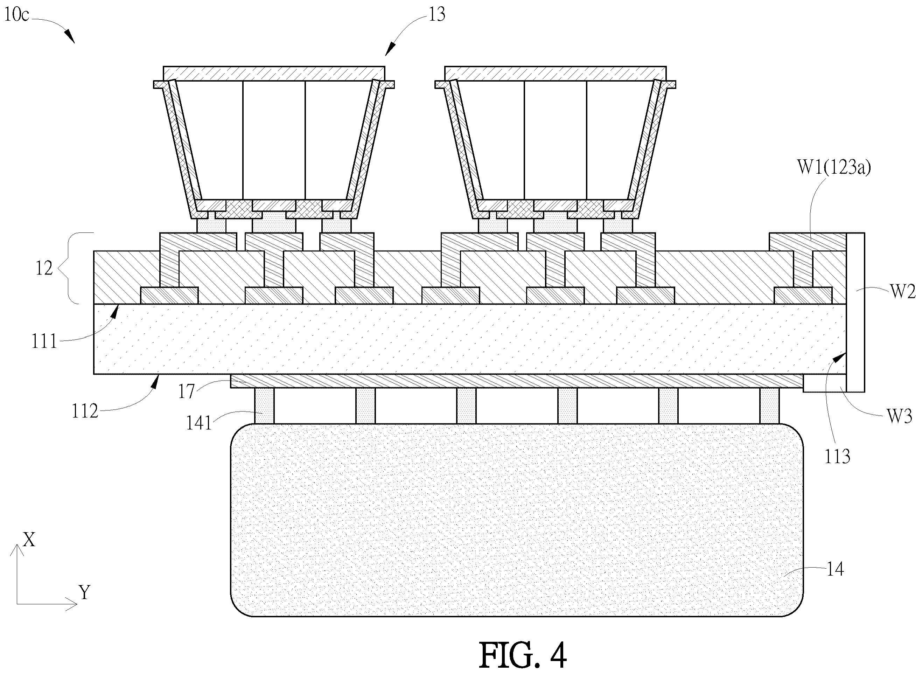

FIG. 4 is a schematic diagram showing an electronic device 10c according to a fourth embodiment of this invention.

The component arrangements and connections of the electronic device 10c of this embodiment are mostly the same as those of the electronic device 10b of the previous embodiment. Unlike the previous embodiment, in the electronic device 10c of this embodiment, the substrate 11 includes a first surface 111, a second surface 112 opposite to the first surface 111, and at least one side surface 113 located between the first surface 111 and the second surface 112. The circuit layer 12 further includes a first wire W1 formed on the first surface 111. The electronic device 10c further includes a second wire W2 and a third wire W3. The second wire W2 is disposed on the side surface 113, and the third wire W3 is disposed on the second surface 112. The sensing element 14 is connected to the third wire W3 through the connecting pin 141 and the circuit layer 17, and is further electrically connected to the first wire W1 of the circuit layer 12 through the third wire W3 and the second wire W2. In this case, the circuit layer 17 can be, for example, a metal layer and is disposed on the second surface 112 of the substrate 11. The first wire W1 can be a part of the metal layer 123a of the circuit layer 12. One end of the second wire W2 is electrically connected to the first wire W1, and the other end thereof is electrically connected to one end of the third wire W3. The other end of the third wire W3 is electrically connected to the circuit layer 17. In one embodiment, the second wire W2 and the third wire W3 can be the same metal layer, or composed of different metal layers, and this invention is not limited thereto. In other embodiments, the second wire W2, the third wire W3 and the circuit layer 17 can be the same metal layer, or composed of different metal layers, and this invention is not limited thereto. To be noted, the above description is for an illustration, and is not intended to limit the scope of the present invention. In addition, on a projection plane perpendicular to the first direction X, the projection of the sensing element 14 may overlap the projection of one or more semiconductor chips 13, and this invention is not limited thereto.

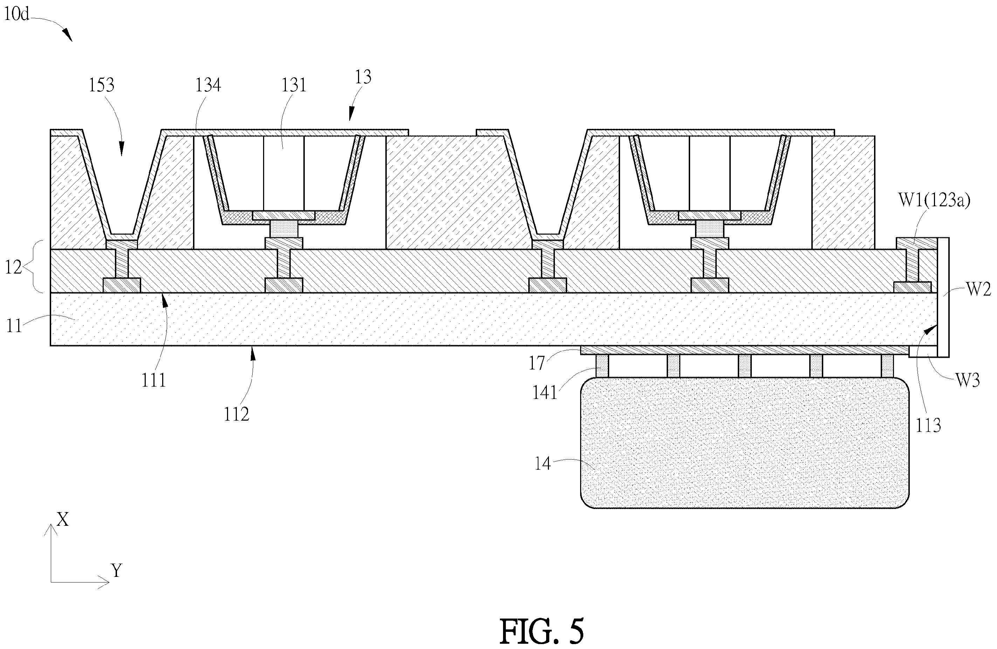

FIG. 5 is a schematic diagram showing an electronic device 10d according to a fifth embodiment of this invention.

The component arrangements and connections of the electronic device 10d of this embodiment are mostly the same as those of the electronic device 10c of the previous embodiment. Unlike the previous embodiment, in the electronic device 10d of this embodiment, the p-type semiconductor layer of the semiconductor die 131, instead of electrically connecting the circuit layer 12 through the reflective layer 133, is directly electrically connected to the circuit layer 12 through the transparent conductive layer 134 that extends into the third opening 153, or is electrically connected to the circuit layer 12 through the transparent conductive layer 134 and a conductive material (not shown) disposed in the third opening 153. This structure can refer to the electronic device 10a as shown in FIG. 2, so the detailed description thereof will be omitted. To be noted, the above description is for an illustration, and is not intended to limit the scope of the present invention.

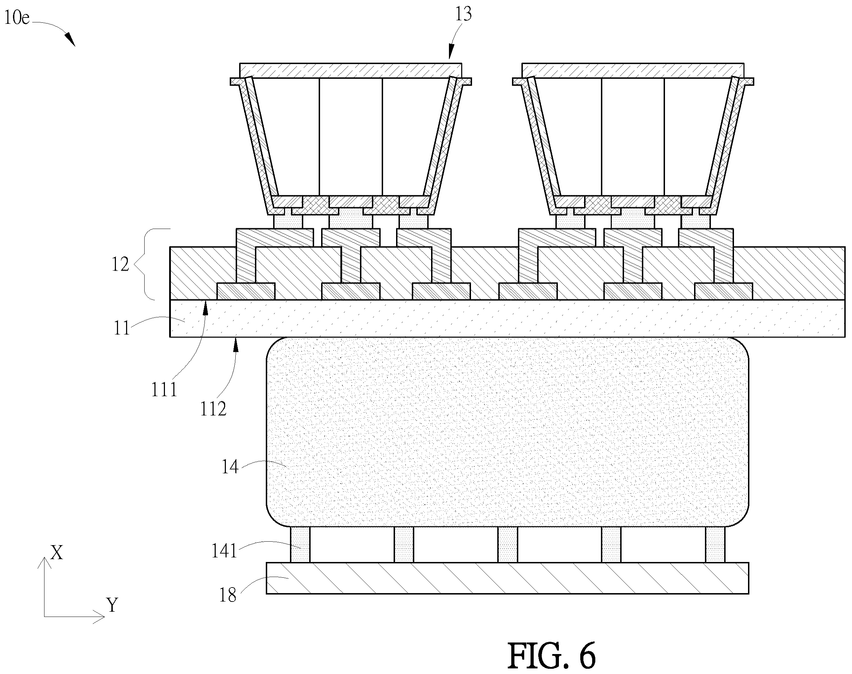

FIG. 6 is a schematic diagram showing an electronic device 10e according to a sixth embodiment of this invention.

The component arrangements and connections of the electronic device 10e of this embodiment are mostly the same as those of the electronic device 10c of the previous embodiment. Unlike the previous embodiment, the electronic device 10e of this embodiment does not include the first wire W1, the second wire W2, the third wire W3 and the circuit layer 17, but further includes a circuit board 18 disposed at one side of the substrate away from the circuit layer 12, while the sensing element 14 is disposed on the circuit board 18. Specifically, the circuit layer 12 is disposed on the first surface 111 of the substrate 11, the circuit board 18 is disposed adjacent to the second surface 112 of the substrate 11, and the sensing element 14 is directly and electrically connected to the circuit board 18 through the connecting pins 141. To be noted, the above description is for an illustration, and is not intended to limit the scope of the present invention. In addition, on a projection plane perpendicular to the first direction X, the projection of the sensing element 14 may overlap the projection of one or more semiconductor chips 13, and this invention is not limited thereto.

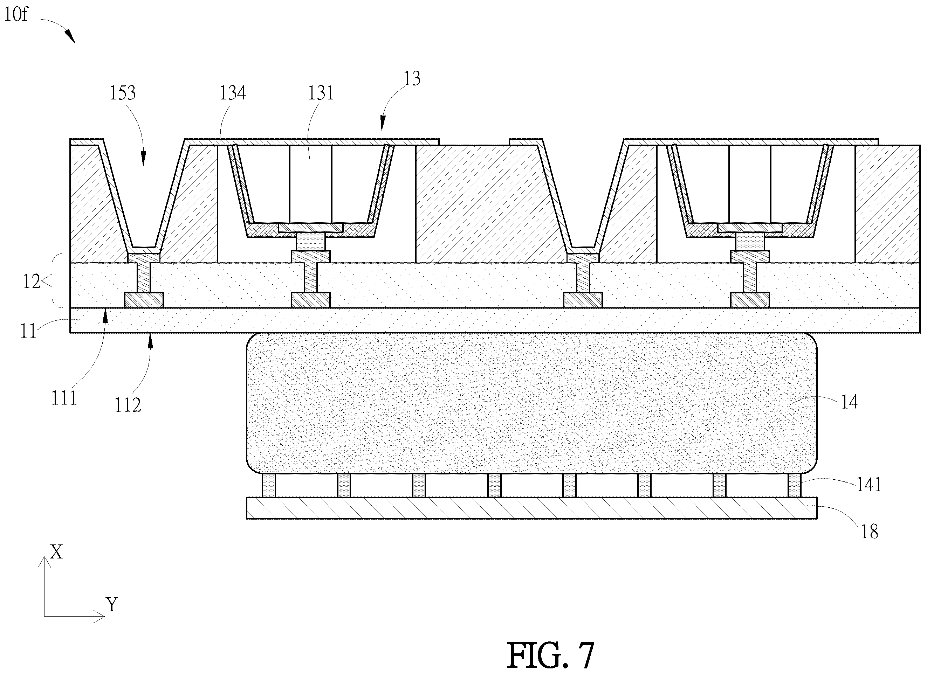

FIG. 7 is a schematic diagram showing an electronic device 10f according to a seventh embodiment of this invention.

The component arrangements and connections of the electronic device 10f of this embodiment are mostly the same as those of the electronic device 10e of the previous embodiment. Unlike the previous embodiment, in the electronic device 10f of this embodiment, the p-type semiconductor layer of the semiconductor die 131, instead of electrically connecting the circuit layer 12 through the reflective layer 133, is directly electrically connected to the circuit layer 12 through the transparent conductive layer 134 that extends into the third opening 153, or is electrically connected to the circuit layer 12 through the transparent conductive layer 134 and a conductive material (not shown) disposed in the third opening 153. This structure can refer to the electronic device 10a as shown in FIG. 2, so the detailed description thereof will be omitted. To be noted, the above description is for an illustration, and is not intended to limit the scope of the present invention. In addition, on a projection plane perpendicular to the first direction X, the projection of the sensing element 14 may overlap the projection of one or more semiconductor chips 13, and this invention is not limited thereto.

In summary, the electronic device of this invention includes a substrate, a circuit layer disposed on the substrate, a semiconductor chip disposed on the substrate and electrically connected to the circuit layer, and a sensing element at least partially overlapped with the substrate. The semiconductor chip includes a semiconductor die, an underfill layer surrounding the semiconductor die, a reflective layer arranged around the underfill layer, and a transparent conductive layer arranged on the semiconductor die and electrically connected to the circuit layer. Based on this design of the electronic device, the semiconductor chip can be a VEFC or a VEC, which it has its own reflective light-collecting structure (i.e., reflective layer), which inherently includes a reflective light-collecting structure (i.e., the reflective layer), so that the circuit layout of the circuit layer on the substrate can be reduced. Therefore, a circuit layout for connecting the sensing element can be added to the circuit layer without additional back plate mechanism, so that this invention can achieve an integrated structure in which the semiconductor chip and the sensing element are simultaneously arranged on the same circuit substrate.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic device, comprising:
a substrate;
a circuit layer disposed on the substrate;
a semiconductor chip disposed over the substrate and the circuit layer and electrically connected to the circuit layer, wherein the semiconductor chip comprises a semiconductor die, an underfill layer surrounding the semiconductor die, a reflective layer arranged around the underfill layer, and a transparent conductive layer arranged on the semiconductor die and electrically connected to the circuit layer; and
a sensing element at least partially overlapped with the substrate.

2. The electronic device of claim 1, wherein the semiconductor chip comprises a vertical embedded flip chip (VEFC) or a vertical embedded chip (VEC).

3. The electronic device of claim 1, wherein the transparent conductive layer and the circuit layer are electrically connected through the reflective layer.

4. The electronic device of claim 1, wherein the sensing element is disposed on the substrate and electrically connected to the circuit layer.

5. The electronic device of claim 1, further comprising:
an insulating layer disposed on the circuit layer, wherein the insulating layer comprises a first opening for accommodating the semiconductor chip, a second opening for accommodating the sensing element, and a third opening for electrically connecting the transparent conductive layer and the circuit layer.

6. The electronic device of claim 5, wherein the third opening is provided with a conductive material, and the transparent conductive layer and the circuit layer are electrically connected through the conductive material in the third opening.

7. The electronic device of claim 1, further comprising a flexible circuit board, wherein the sensing element is disposed on the flexible circuit board and is electrically connected to the circuit layer through the flexible circuit board.

8. The electronic device of claim 1, wherein the substrate comprises a first surface, a second surface opposite to the first surface, and at least one side surface arranged between the first surface and the second surface, the circuit layer comprises a first wire formed on the first surface, the electronic device further comprises a second wire and a third wire, the second wire is disposed on the at least one side surface, the third wire is disposed on the second surface, and the sensing element is electrically connected to the first wire of the circuit layer through the second wire and the third wire.

9. The electronic device of claim 1, further comprising a circuit board disposed at one side of the substrate away from the circuit layer, wherein the sensing element is disposed on the circuit board.

10. The electronic device of claim 1, wherein the sensing element comprises a fingerprint sensor, a photo sensor, an acoustic sensor or a tactile sensor.
